# EUROPEAN PATENT APPLICATION

(11) **EP 4 307 384 A2**
(43) Date of publication of application: **17.01.2024**
(21) Application number: 23181494.8
(22) Date of filing: 26.06.2023
(51) Int. Cl.: H01L 29/06, H01L 29/49, H01L 29/78, H01L 29/423

(54) **POWER MOSFET DEVICE WITH IMPROVED ISOLATED GATE STRUCTURE AND MANUFACTURING PROCESS THEREOF**

(30) Priority: 11.07.2022 IT 202200014566
(71) Applicant: STMicroelectronics S.r.l., 20864 Agrate Brianza (MB) (IT)
(72) Inventor: CAMALLERI, Cateno Marco, 95125 CATANIA (IT); SAGGIO, Mario Giuseppe, 95020 ACI BONACCORSI (CT) (IT); GUARNERA, Alfio, 95039 TRECASTAGNI (CT) (IT)
(74) Representative: Studio Torta S.p.A.

(57) **Abstract**

A power MOSFET device (1) comprises a semiconductor body (3) having a first main surface (3a). The semiconductor body (3) includes an active area (7) facing the first main surface (3a). The power MOSFET device (1) comprises an isolated-gate structure (15), which extends over the active area (7) and includes a gate-oxide layer (12), which is made of insulating material and extends over the first main surface (3a), and a gate region (24) buried in the gate-oxide layer (12) so as to be electrically insulated from the semiconductor body (3). The gate region (24) comprises a gate layer (14) of polysilicon and at least one first silicide region (25a) and one second silicide region (25b), which extend in the gate layer (14) so as to face a top surface (14a) of the gate layer (14) and to be arranged alongside one another and spaced apart from one another in a first plane (XY).

## Description

The present invention relates to a power MOSFET device with improved isolated-gate structure and to a manufacturing process thereof. In particular, the isolated-gate structure has a gate region buried in a gate-oxide layer, where the gate region comprises a gate layer of polysilicon and a plurality of silicide regions, which enable local modification of the electrical resistance of the gate region.

As is known, power devices are electronic devices designed to work at high voltages and currents, for example with voltages that reach 1700 V in the inhibition state, and as much as several tens or hundreds of amps of current in the conduction state.

In particular, semiconductor power devices are known based, for example, upon silicon, gallium nitride (GaN), silicon carbide (SiC), gallium arsenide (GaAs). For instance, thanks to a high thermal capacity, SiC may operate up to approximately 400°C and has the possibility of withstanding high powers (of even hundreds of watts) and may work at high the frequencies (of hundreds of megahertz).

Power devices find use in multiple fields of application. For instance, they are commonly used as switched-mode power supplies (SMPS), audio amplifiers, engine controls, energy-conversion devices, devices in the automotive field for hybrid and electric vehicles.

For instance, power devices comprise power diodes, power transistors with finger-electrode structure, thyristors, MOSFETs (Metal-Oxide-Semiconductor Field-Effect Transistors), and SJ-MOSFETs (Super-Junction MOSFETs).

However, it is known that electrical control of power devices may present critical aspects, for example due to the wide extension of the active area of the power device or else to specific layouts of the power device that may generate delays in the propagation of the control signals (e.g., source voltage) and consequently delays in switching of the state of the power device (e.g., ON/OFF state).

In particular, it is known that power devices may switch locally at different times (i.e., some regions of the power device switch on/off before others) and this leads to degraded electrical performance and to the risk of damage to the power device. In fact, when switching of state of the power device does not occur in a uniform and simultaneous way within the entire power device but rather occurs in a localized way and at different times, it is possible for high current densities to be generated (in general, higher than expected and considered in the design stage) in specific and localized regions of the power device, and this may cause excessive heating of these regions, which may lead to damage to the power device by the Joule effect.

Consequently, currently known power devices present limitations in the transmission of the control signals, which decrease their reliability and deteriorate operation and electrical performance thereof.

Furthermore, at present no simple and low-cost solutions are known that enable local control of propagation of the control signals on the basis of the design requirements of the power devices, for example by deliberately delaying or accelerating the control signals thereof in predefined regions of the power device to enable switching thereof that is shifted (e.g., postponed or anticipated) with respect to other regions of the power device, or else to enable simultaneous and homogeneous switching in the entire power device. Consequently, it is not possible to control effectively the power device in such a way that the latter switches in every point in a substantially simultaneous way (e.g., in a time interval shorter than approximately 50 ns) or else in such a way as to switch some regions before others, according to the application and the desired requirements of use.

Document EP 1 659 636 A1 relates to a power electronic device, such as a MOS device, of the type comprising a very high integration of elementary MOS transistors and used in multiple applications both at low and high supply voltage.

Document Shenai K et al., "Selectively silicided vertical power double-diffused metal-oxide semiconductor field effect transistors for high-frequency power switching applications", Journal of Vacuum Science and Technology, 6 November 1988 relates to a FET structure with selectively silicided gate and source regions.

The aim of the present invention is to provide a power MOSFET device with improved isolated-gate structure and a manufacturing process thereof that will overcome the drawbacks of the prior art.

According to the present invention a power MOSFET device with improved isolated-gate structure and a manufacturing process thereof are provided, as defined in the annexed claims.

For a better understanding of the present invention, a preferred embodiment is now described, purely by way of non-limiting example, with reference to the attached drawings, wherein:
- Figure 1 is a cross-sectional view, taken along the line of section I-I of Figure 2, of a power device according to an embodiment provided by way of example;
- Figure 2 and Figures 3A and 3B are respective top plan views with parts removed, taken along the line of section A-A of Figure 1, of the power device of Figure 1, according to respective embodiments;
- Figure 4 is a longitudinal sectional view with parts removed, taken along the line of section IV-IV of Figure 1, of the power device of Figure 1, according to an embodiment provided by way of example;
- Figure 5 is a top plan view of a gate structure of the power device of Figure 1, according to an embodiment;
- Figure 6 is a top plan view with parts removed of the power device of Figure 1, according to a further embodiment; and
- Figures 7A-7G are longitudinal sectional views that show respective steps for manufacturing the power device of Figure 4, according to an embodiment provided by way of example.

In particular, the illustrations in the figures are drawn with reference to a triaxial cartesian system defined by an axis X, an axis Y, and an axis (or first axis) Z, orthogonal to one another.

In the ensuing description, elements common to the various embodiments are designated by the same reference numbers.

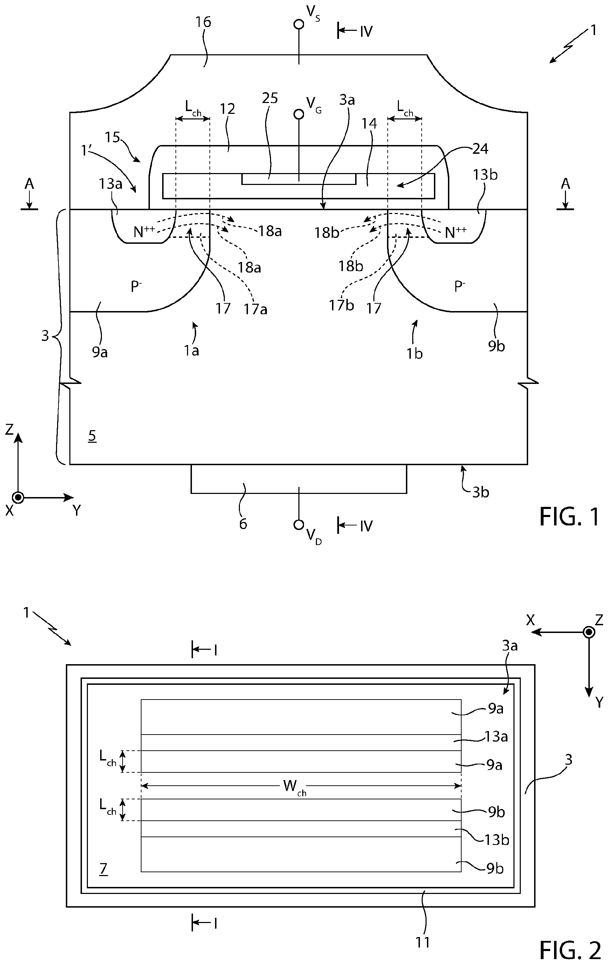

Figure 1 shows a power device (in detail, of a power MOSFET type) 1, according to an embodiment described and provided by way of example. In particular, Figure 1 shows by way of example an elementary cell 1' of the power device 1; however, and in a way of itself known to the person skilled in the art, the power device 1 may comprise a plurality of elementary cells 1' electrically connected together, for example in parallel.

The elementary cell 1' of the power device 1 has a direction of main extension parallel to the axis X, and Figure 1 shows a cross-sectional view of the elementary cell 1' in a plane YZ defined by the axes Y and Z, thus in a direction perpendicular to the aforesaid direction of main extension.

The elementary cell 1' includes a semiconductor body 3 of semiconductor material, for example SiC or silicon, having a front surface (or first main surface) 3a and a rear surface (or second main surface) 3b. The semiconductor body 3, common to all the elementary cells 1', comprises a drain region 5, which has a first conductivity type (for example, of an N type) and a first conductivity value and extends in the semiconductor body 3 starting from the rear surface 3b towards the front surface 3a. A drain metallization 6 extends on the rear surface 3b, in direct electrical contact with the drain region 5 and forms an electrical drain terminal.

A first body region 9a and a second body region 9b extend in the semiconductor body 3 starting from the front surface 3a towards the rear surface 3b, without reaching the latter, and are physically separated from one another (in a direction parallel to the axis Y) and from the rear surface 3b (in a direction parallel to the axis Z) via the drain region 5. Both the first body region 9a and the second body region 9b have a second conductivity type (here, of a P type) and a second conductivity value.

A first source region 13a and a second source region 13b, which have the first conductivity type (here, of an N type) and a third conductivity value higher than the first conductivity value, extend into the first body region 9a and the second body region 9b, respectively, starting from the front surface 3a. In a direction parallel to the axis Y, each source region 13a, 13b is physically separated (i.e., arranged at a distance) from the drain region 5 via a respective portion of the first body region 9a and of the second body region 9b, respectively, which form a first channel region 17a and a second channel region 17b, respectively (which thus have the second conductivity value).

Purely by way of non-limiting example, the elementary cell 1' may have: a channel length L_{ch} of the body regions 9a, 9b (for instance, measured in a direction parallel to the axis Y), for example comprised between 150 nm and 1000 nm, in particular approximately 500 nm; the first doping value of the drain region 5 comprised between 1.10¹⁵ ions/cm³ and 5.10¹⁷ ions/cm³, for example approximately 2.10¹⁶ ions/cm³; the second doping value for implantation of the body regions 9a, 9b comprised approximately between 1.10¹³ ions/cm² and 5·10¹⁵ ions/cm²; and the third doping value for implantation of the source regions 13a, 13b comprised between 1.10¹⁵ ions/cm² and 5·10¹⁶ ions/cm², for example approximately 1·10¹⁶ ions/cm².

The power device 1 further comprises a gate structure (also referred to as "isolated-gate structure") 15, which, in the embodiment illustrated by way of example in Figure 1, overlies, along the axis Z, the channel regions 17a, 17b of the body regions 9a, 9b and the portion of the drain region 5 arranged along the axis Y between the body regions 9a, 9b.

The gate structure 15 comprises an oxide layer (or gate-oxide layer) 12, on the front surface 3a, and a gate region 24 buried in the oxide layer 12 so as to be isolated physically and electrically from the semiconductor body 3 (in particular, from the front surface 3a of the semiconductor body 3). The gate region 24 is electrically connected to a gate metallization (not shown), in a per se known manner to the person skilled in the art.

The oxide layer 12 is made of insulating material such as oxide, for example silicon dioxide (SiO₂).

The gate region 24 comprises a gate layer 14 of polysilicon, which, in the embodiment illustrated by way of example in Figure 1, overlies, along the axis Z, the channel regions 17a, 17b of the body regions 9a, 9b and the portion of the drain region 5 arranged along the axis Y between the body regions 9a, 9b. In particular, the gate layer 14 is made of doped polysilicon and has, for example, the first electrical conductivity type (here, of an N type) and a fourth doping value that, purely by way of example, is comprised between approximately 5·10¹⁸ ions/cm² and approximately 1·10²¹ ions/cm², for example approximately 5·10¹⁹ ions/cm².

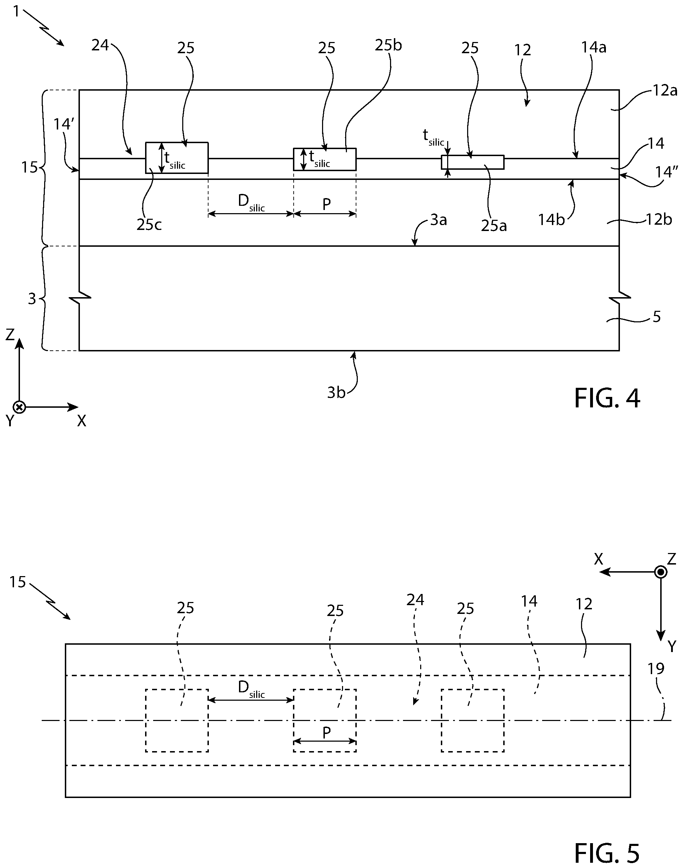

The gate region 24 further comprises a plurality of silicide regions (also called in the following electrical-modulation regions, or silicide islands) 25, of silicide such as TiSi₂, CoSi₂, NiSi, WSi₂. In what follows, considered by way of example is the case where the electrical-modulation regions 25 are made of TiSi₂, even though it is evident that other silicides (i.e., binary chemical compounds formed by metals or semimetals and silicon) may likewise be used. The electrical-modulation regions 25 are, for example, housed in the gate layer 14 and are fully described in what follows with reference to Figure 4.

A source metallization 16 (defining an electrical source terminal of conductive material, such as metal) extends on the oxide layer 12 and on the front surface 3a, where the latter is not covered by the oxide layer 12, and is in direct electrical contact with the source regions 13a, 13b and the body regions 9a, 9b, which are thus electrically coupled together.

Optionally and in a way not shown or discussed further, one or more passivation layers may extend on the source metallization 16.

In practice, the drain metallization 6, the drain region 5, the first body region 9a, the first source region 13a, the gate layer 14, the oxide layer 12, and the source metallization 16 form a first device portion 1a, while the drain metallization 6, the drain region 5, the second body region 9b, the second source region 13b, the gate layer 14, the oxide layer 12, and the source metallization 16 form a second device portion 1b.

Figure 2 shows the power device 1 in top plan view, parallel to a plane XY (also referred to as "first plane XY") defined by the axes X and Y, where for simplicity of representation the gate structure 15 and the source metallization 16 are not shown.

As may be noted in Figure 2, the channel regions 17a, 17b of the device portions 1a, 1b have a width, in a direction parallel to the axis X, for example equal to one another and equal to a channel extension W_{ch} (also referred to as channel length W_{ch}), for example comprised between approximately 100 nm and approximately 1 um.

Further, as may be seen in Figure 2, the elementary cell 1' extends within an active region 7 of the power device 1; in the case of a plurality of elementary cells 1', they likewise extend inside the active region 7 and share the gate structure 15. In particular, the semiconductor body 3 includes a field isolation region 11 (of insulating material, such as SiO₂) having a closed shape and delimiting the active region 7 of the power device 1. The isolation region 11 has the function of electrically insulating the active region 7 (and consequently the one or more elementary cells 1') from the remaining portion of semiconductor body 3. The active region 7 and the one or more elementary cells 1' included therein are thus galvanically insulated with respect to possible further devices comprised in the semiconductor body 3 but external to the active region 7.

In detail, in the case of a number of elementary cells 1', each of them shares the drain region 5, the drain metallization 6, and the source metallization 16. Furthermore, the elementary cells 1' share the gate layer 14, which is common to all the elementary cells 1'.

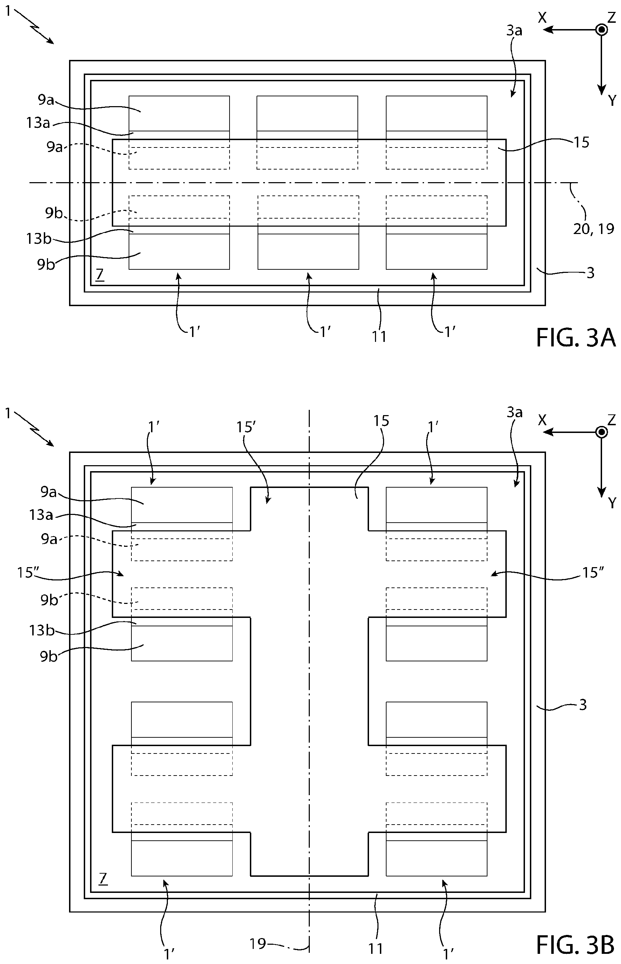

For instance, Figure 3A shows an embodiment of the power device 1, in top plan view, where for simplicity of representation the source metallization 16 and the gate region 24 are not shown. In Figure 3A, the power device 1 comprises a number of elementary cells 1' electrically connected together.

As shown in Figure 3A, the elementary cells 1' may be aligned with one another along an axis of alignment 20 parallel to the axis X and to the direction of main extension of each elementary cell 1' so as to form an array of elementary cells 1'. In other words, the first and second source regions 13a and 13b of each elementary cell 1' are aligned with one another in a direction orthogonal to the axis of alignment 20. The gate structure 15 overlies each elementary cell 1' and has a respective direction of main extension 19 that is parallel to the axis of alignment 20. For instance, the gate structure 15 is here strip-shaped, with main extension in the direction of main extension.

Figure 3B shows a different embodiment of the power device 1, in top plan view where for simplicity of representation the source metallization 16 and the gate region 24 are not shown. In Figure 3B, the power device 1 comprises a number of elementary cells 1' electrically connected together.

As shown in Figure 3B, the gate structure 15 may have a main portion 15' having a direction of main extension 19 for example parallel to the axis Y, and a plurality of secondary portions 15", which extend from the main portion 15' in a way transverse to the latter. In other words, each secondary portion 15" has a respective main extension that is transverse to the direction of main extension 19 and here for example parallel to the axis X. For instance, the main portion 15' is here strip-shaped having the aforesaid direction of main extension 19, whereas the secondary portions 15" may extend two by two on sides of the main portion 15' that are opposite to one another along the axis X, and each pair of secondary portions 15" may have the respective secondary portions 15" coaxial (i.e., the respective main extensions are aligned with one another in a direction parallel to the axis X).

Each secondary portion 15" may, for example, overlie, along the axis Z, a respective one of the elementary cells 1'. Consequently, each elementary cell 1' has the first and second source regions 13a and 13b that are, for example, aligned with one another in a direction parallel to the direction of main extension 19.

Figure 4 shows a longitudinal sectional view of the power device 1, taken along a line of section IV-IV shown in Figure 1 and taken in an area corresponding to the gate layer 14 and the electrical-modulation regions 25. In detail, this view is in a plane XZ defined by the axes X and Z. For simplicity of representation, Figure 4 does not show the source metallization 16 and the drain metallization 6.

Figure 4 shows the electrical-modulation regions 25. Purely by way of non-limiting example, Figure 4 shows a first electrical-modulation region 25a, a second electrical-modulation region 25b, and a third electrical-modulation region 25c; however, the number of electrical-modulation regions 25 may vary and may for example be two or more than three.

In detail, the gate layer 14 has a top surface 14a and a bottom surface 14b opposite to one another along the axis Z. The top surface 14a faces a top portion 12a of the oxide layer 12, arranged, along the axis Z, between the gate layer 14 and the source metallization 16, while the bottom surface 14b faces a bottom portion 12b of the oxide layer 12, arranged, along the axis Z, between the gate layer 14 and the drain region 5.

The electrical-modulation regions 25 extend in the gate layer 14 at the top surface 14a of the gate layer 14 so as to face the top surface 14a and to be arranged alongside one another and spaced apart in the plane XY (i.e., to be arranged alongside one another).

In particular, the electrical-modulation regions 25 are at a distance from one another in a direction parallel to the plane XY; for example, they are aligned with one another along the axis X and/or the axis Y to form an array and/or a matrix pattern; purely by way of example, Figure 4 shows the electrical-modulation regions 25a, 25b, 25c aligned along the axis X. The electrical-modulation regions 25 are arranged apart from one another in a direction parallel to the plane XY by the gate layer 14.

In detail, the electrical-modulation regions 25 extend in the gate layer 14 from the top surface 14a to the bottom surface 14b. The electrical-modulation regions 25 may reach the bottom surface 14b or else extend at a distance, along the axis Z, from the bottom surface 14b. Furthermore, the electrical-modulation regions 25 may protrude outside of the gate layer 14 and extend partially in the top portion 12a of the oxide layer 12.

The electrical-modulation regions 25 have, in a plane parallel to the plane XY, a shape (i.e., a cross section) that is a closed polygon, such as a square, a triangle, a rectangle, a hexagon, etc. In what follows, by way of example the electrical-modulation regions 25 are considered as having a square shape even though other shapes may likewise be considered.

Each electrical-modulation region 25 has a thickness t_{silic} measured along the axis Z (e.g., maximum thickness, for example measured between a top surface and a bottom surface of the electrical-modulation regions 25, opposite to one another, along the axis Z) and has an area of extension A_{silic} measured in a plane parallel to the plane XY (e.g., area of maximum extension). Further, for more than two electrical-modulation regions 25, each pair of electrical-modulation regions 25 that are adjacent to one another in a direction parallel to the plane XY has a minimum distance D_{silic} that is the minimum distance between said electrical-modulation regions 25, measured, for example, along the axis X or the axis Y.

The shape of the electrical-modulation regions 25 in a plane parallel to the plane XY, the thickness t_{silic}, the area of extension A_{silic}, and the minimum distance D_{silic} are also referred to in what follows as structural parameters of the electrical-modulation regions 25.

The electrical-modulation regions 25 have structural parameters that may be different from one another. In other words, at least one of the electrical-modulation regions 25 may have at least one of the structural parameters (the shape, the thickness t_{silic}, the area of extension A_{silic} and the minimum distance D_{silic}) that is different from that of the other electrical-modulation regions 25. Alternatively, all the electrical-modulation regions 25 have the same structural parameters.

In the embodiment considered by way of example in Figure 4, the electrical-modulation regions 25a, 25b and 25c have the same shape, area of extension A_{silic}, and minimum distance D_{silic}, but have the thickness t_{silic} that varies.

In particular, the structural parameters of the electrical-modulation regions 25 are chosen heuristically in the stage of design of the power device 1 in order to achieve predefined and specific targets for the application in which the power device 1 will be used.

In fact, silicides have an electrical resistivity that is generally much lower than that of the polysilicon of the gate layer 14, for example lower by approximately two orders of magnitude. For instance, the electrical resistivity of the polysilicon is comprised between approximately 1 Ω·m and approximately 100 Ω·m and the electrical resistivity of TiSi₂ is comprised between approximately 0.01 Ω·m and approximately 1 Ω·m. Consequently, the presence of the electrical-modulation regions 25 reduces the overall electrical resistance of the gate region 24 as compared to the case where the electrical-modulation regions 25 are not present and above all enables local modulation of the electrical resistance of the gate region 24, enabling localized and selective variation of the electrical properties of the power device 1 (e.g., the rate of switching from the ON state to the OFF state and vice versa, in predefined regions of the power device 1).

In particular, in some applications it may be useful to have one or more first portions of the gate region 24 at a lower electrical resistance and one or more second portions of the gate region 24 at a higher electrical resistance, arranged alongside (e.g., adjacent in a direction orthogonal to the axis Z) the one or more first portions of the gate region 24. In this case, the one or more first portions of the gate region 24 comprise the electrical-modulation regions 25 whereas the one or more second portions of the gate region 24 do not.

Furthermore, the possibility of varying the structural parameters of the electrical-modulation regions 25 and the number of the latter in the gate structure 15 enables control, in the design stage, of the electrical resistance of the gate region 24 with greater accuracy. For instance, one or more first sub-portions of the one or more first portions of the gate region 24 may present, relative to one or more second sub-portions of the one or more first portions of the gate region 24 (with a higher electrical resistance than the one or more first sub-portions and arranged alongside the one or more first sub-portions), at least one of the following: a greater number of electrical-modulation regions 25, a larger thickness t_{silic}, a greater area of extension A_{silic}, and a smaller minimum distance D_{silic}.

Purely by way of example, there is here considered the embodiment of Figure 3A, where the gate structure 15 is strip-shaped and has the direction of main extension 19. Consequently, also the gate layer 14 has its main extension in the direction of main extension 19 and has a first end 14' and a second end 14" (Figure 4) opposite to one another in the direction of main extension 19. For instance, it is required for the electrical resistance of the gate region 24 to increase proceeding from the first end 14' to the second end 14". In this case, proceeding from the first end 14' to the second end 14", the gate region 24 is designed in such a way that at least one of the following criteria applies: the number of electrical-modulation regions 25 decreases, the thickness t_{silic} decreases, the area of extension A_{silic} decreases, and the minimum distance D_{silic} increases. For instance, Figure 4 shows the case where the electrical resistance of the gate region 24 increases proceeding from the first end 14' to the second end 14" via a reduction of the thickness t_{silic} proceeding from the first end 14' to the second end 14".

Figure 5 shows a top plan view of the gate structure 15 of Figure 4. In the embodiment illustrated by way of example in Figure 5, the electrical-modulation regions 25 have a square shape in a plane parallel to the plane XY, with side P (e.g., greater than approximately 0.2 um and for example equal to approximately 1 µm). Further, the electrical-modulation regions 25 are, for example, spaced at equal distances apart in the direction of main extension 19.

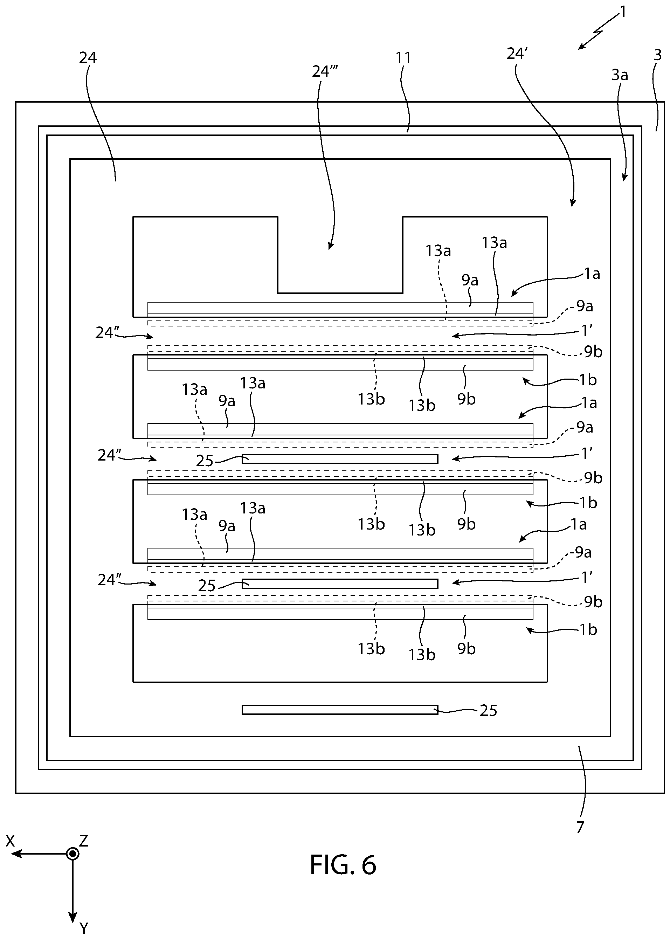

Figure 6 is a schematic illustration, in top plan view, of a further example of the gate region 24, in particular of the arrangement of the electrical-modulation regions 25 in the gate layer 14.

In particular, Figure 6 shows a top plan view of a further embodiment of the power device 1, where for simplicity of representation the source metallization 16 and the oxide layer 12 are not shown (more in general, what extends above the gate region 24 along the axis Z is not shown). The body regions 9a, 9b, the source regions 13a, 13b and the drain region 5 that underlie the gate region 24 are shown with the edges in solid lines where they are exposed along the axis Z by the gate region 24 and with the edges in dashed lines where they are covered along the axis Z by the gate region 24. The electrical-modulation regions 25 are also shown with edges in solid lines since they are at the upper surface of the gate region 24.

In Figure 6, the power device 1 comprises, by way of example, a number of elementary cells 1' electrically connected together.

As shown in Figure 6, the gate region 24 may present a main portion 24' that for example is coupled (e.g., with continuity, i.e. in an integral way) to an electrical connection portion 24‴ to which for example the gate metallization may be coupled. For instance, the main portion 24' has the shape of a polygonal frame, for example a square frame, and defines an inner region that extends inside the polygonal frame (i.e., is externally delimited thereby). Extending in this inner region are secondary portions 24" of the gate region 24, each secondary portion 24" forming part of a respective elementary cell 1' (i.e., overlying, along the axis Z, a respective first device portion 1a and a respective second device portion 1b, as shown in Figure 1). For example, Figure 1 shows in detail one of these secondary portions 24" of the gate region 24, in cross section. Each secondary portion 24" has respective ends (e.g., opposite to one another along the axis X) coupled to the main portion 24'. For instance, the secondary portions 24" extend between sides of the square frame opposite to one another along the axis X so as to be parallel to one another and to the axis X.

The electrical-modulation regions 25 may extend in some of the secondary portions 24" and, optionally, also in part of the main portion 24'.

For instance, the electrical-modulation regions 25 may extend in a first set of secondary portions 24" and do not extend in a second set of secondary portions 24". By way of example and as shown in Figure 6, the first set extends on the opposite side of the gate region 24 with respect to the electrical connection region 24‴, for example along the axis Y, whereas the second set extends between the electrical connection region 24‴ and the first set. Consequently, the secondary portions 24" of the first set form the first portions of the gate region 24 with a lower electrical resistance, and the secondary portions 24" of the second set form the second portions of the gate region 24 with a higher electrical resistance.

For example, the electrical-modulation regions 25 may extend in central areas of the secondary portions 24" (as shown in Figure 6) or in end areas of the secondary portions 24". In particular, the central areas of the secondary portions 24" are regions of the secondary portions 24" that, along the axis X, are arranged at the centre and are arranged between the end areas of the secondary portions 24" (for example, they are arranged so as to be equidistant from the ends of the secondary portions 24" coupled to the main portion 24'); instead, the end areas of the secondary portions 24" are arranged alongside the central areas of the secondary portions 24" and define said ends of the secondary portions 24" that are coupled to the main portion 24'. In the example of Figure 6, for each secondary portion 24" provided with electrical-modulation regions 25, the central area of the secondary portion 24" forms the first portion of the gate region 24 with a lower electrical resistance, and the end areas of the secondary portions 24" form the second portions of the gate region 24 with a higher electrical resistance.

In a known way, during use, the power device 1 is biased by applying a source voltage V_{S} to the source metallization 16 (for example, a ground reference voltage GND), whereas a drain voltage V_{D} (e.g., from 30 V to 1700 V) is applied to the drain metallization 6. Further, when the gate region 24 is biased, via the gate metallization, to a gate voltage V_{G} such as to generate respective flows of charge carriers (here electrons) 18a, 18b through the channel regions 17a, 17b, respectively (as shown in Figure 2), the power device is in the conduction state (ON state); otherwise, the power device is in the inhibition state (OFF state). Thus, in use, the overall conduction of the power device 1 is a function of both of the flows of electrons 18a, 18b (each corresponding to a respective device portion 1a, 1b).

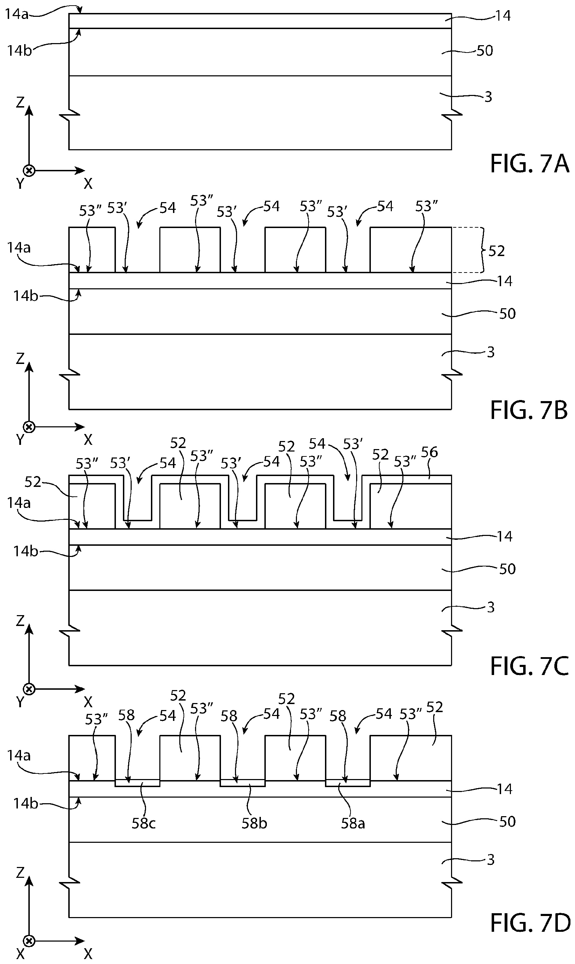

Figures 7A-7G show respective steps of a process for manufacturing the power device 1, in particular the embodiment of Figure 4. Even though the manufacturing process of Figures 7A-7G is illustrated by way of example with reference to the power device 1 of Figure 4 (e.g., with the electrical-modulation regions 25 by way of example equally spaced apart along the axis X and with different thicknesses t_{silic}), manufacture of the other embodiments of the power device 1 described previously is similar and obvious to the person skilled in the art on the basis of what will be described below. Consequently, it is not described any further.

With reference to Figure 7A, initially the semiconductor body 3 is formed in a way of itself known. For simplicity of representation, Figures 7A-7G do not show the drain region 5, the body regions 9a, 9b, or the source regions 13a, 13b.

In particular, a substrate of semiconductor material is provided (which has, in the context of the present description, the first conductivity type, here, of an N type, and is, for example, of SiC) formed on which is a plurality of epitaxial layers (not shown). The result of the epitaxial growth on the substrate is the formation of the drain region 5.

Then, via techniques in themselves known and starting from the front surface 3a, the isolation region 11 delimiting the active region 7 of the power device 1 is formed in the semiconductor body 3.

There then follow, in a per se known manner and via lithographic techniques, formation of the body regions 9a, 9b and, subsequently, formation of the source regions 9a, 9b in the body regions 9a, 9b. However, it is considered obvious to the person skilled in the art that formation of the source regions 13a, 13b may also be obtained, in a per se known manner, prior to or simultaneous with formation of the body regions 9a, 9b. For instance, formation of the body regions 9a, 9b is obtained via a first implantation of first dopants with the second conductivity type (here, of a P type, for example via ions of boron, indium, and aluminium) and a concentration equal to the second doping value referred to above (between approximately 1·10¹² ions/cm² and 1·10¹³ ions/cm²), followed by a step of thermal annealing, which enables redistribution and activation of the first dopants (e.g., conducted in protected environment, for example in a nitrogen or argon atmosphere, at a temperature comprised between 900°C and 1100°C for a time comprised between a few tens of seconds, in the case of rapid thermal annealing - RTA, and a few hours, in the case of an oven). Instead, formation of the source regions 9a, 9b in the body regions 9a, 9b is obtained via a second implantation of second dopants having the first conductivity type (here, of an N type, for example via ions of arsenic, phosphorus, or antimony) and a concentration equal to the third doping value referred to above (between approximately 5·10¹⁵ ions/cm² and 5·10¹⁶ ions/cm²), followed by a similar step of thermal annealing that enables redistribution and activation of the second dopants.

In this way, the semiconductor body 3 is obtained, as shown in Figure 1.

Once again with reference to Figure 7A, a first oxide layer 50 is then formed on the front surface 3a of the semiconductor body 3. The first oxide layer 50, of insulating material such as oxide (e.g., silicon oxide), is to form the bottom portion 12b of the oxide layer 12. For instance, the first oxide layer 50 extends in a uniform way over the front surface 3a of the semiconductor body 3. In particular, the first oxide layer 50 is formed via techniques such as thermal oxidation, wet anodization, chemical vapour deposition (CVD), and plasma anodization. For instance, the first oxide layer 50 is formed by carrying out a thermal process in oxygen atmosphere so as to get the oxygen to react with the silicon of the semiconductor body 3 to create silicon oxide on the front surface 3a of the semiconductor body 3.

There is then formed the gate layer 14 on the first oxide layer 50 (i.e., on a top surface of the first oxide layer 50, opposite to a bottom surface of the first oxide layer 50 facing the semiconductor body 3). For instance, the gate layer 14 extends in a uniform way on the first oxide layer 50. In particular, the gate layer 14 is made of polysilicon (in detail, doped polysilicon, here of an N type, and having the fourth doping value comprised, for example, between approximately 5·10¹⁸ ions/cm² and approximately 1·10²¹ ions/cm²) and is formed via techniques such as chemical vapour deposition of doped polysilicon or else via chemical vapour deposition of polysilicon followed by doping of the polysilicon via ion implantation of dopant species. For instance, the gate layer 14 is formed via low-pressure chemical vapour deposition (LPCVD) in a per se known manner.

With reference to Figure 7B, formation of a first mask layer 52 on the gate layer 14, i.e., on the top surface 14a of the gate layer 14, is then carried out. In particular, the first mask layer 52 exposes first-phase exposed regions 53' of the top surface 14a of the gate layer 14 and covers first-phase covered regions 53" of the top surface 14a of the gate layer 14. In detail, the first-phase exposed regions 53' are arranged alongside one another and separated (i.e., laterally arranged at a distance) from one another in the plane XY, for example along the axis X; in other words, the first-phase exposed regions 53' are staggered one another, in top plan view (i.e., parallel to the plane XY). In the embodiment considered by way of example, the first-phase exposed regions 53' are equally spaced apart along the axis X. In greater detail, the first mask layer 52 has a plurality of first-phase openings 54, which extend through the first mask layer 52 so as to expose the first-phase exposed regions 53', the first-phase openings 54 being arranged alongside one another and arranged apart from one another in the plane XY and by way of example being equally spaced apart along the axis X.

For instance and as considered by way of example in what follows, the first mask layer 52 is made of oxide, such as silicon oxide; however, other materials may likewise be used to produce the first mask layer 52, such as nitride or photoresist. In particular, the first oxide mask layer 52 is formed via deposition, carried out uniformly on the top surface 14a of the gate layer 14, of a first intermediate oxide layer (not shown and of oxide such as silicon oxide). Deposition of the first intermediate oxide layer is carried out like that of the first oxide layer 50 and is consequently not described again in detail. Deposition of the first intermediate oxide layer is followed by a first first-phase etch, which forms the first-phase openings 54 by removing corresponding portions of the first intermediate oxide layer to define the first mask layer 52. For instance, the first first-phase etch is a wet etch (e.g., HF-based) or else a plasma etch (e.g., via chlorine or fluorine compounds, such as XeF₂ or SF₆) and is performed through a first etching mask (not shown) that covers the first intermediate oxide layer leaving exposed the portions of the latter to be removed (i.e., the ones that will form the first-phase openings 54 overlying, along the axis Z, the first-phase exposed regions 53'). In greater detail, this is obtained by forming, via known lithographic techniques, the first etching mask on the first intermediate oxide layer carrying out the first first-phase etch through the first etching mask and then removing the first etching mask (e.g., via the use of an appropriate chemical solvent).

With reference to Figure 7C, a first metal layer 56 is formed on the first mask layer 52 and on the first-phase exposed regions 53' of the top surface 14a of the gate layer 14. In detail, the first metal layer 56 is formed also in the first-phase openings 54 in such a way as to cover the first-phase exposed regions 53'. The first metal layer 56 consists of metal or semimetal, which, by reacting with silicon, may form a silicide. For instance, the first metal layer 56 is made of Ti, Co, Ni, or W; considered by way of non-limiting example in what follows is the case where the first metal layer 56 is made of Ti. For instance, the first metal layer 56 is formed via cathode sputtering or else electroplating in a way of itself known.

With reference to Figure 7D, first-phase silicide sub-regions 58 are formed in the first-phase exposed regions 53'. In particular, the first-phase silicide sub-regions 58 are comprised in the respective electrical-modulation regions 25 and are made of silicide that is generated starting from the silicon present in the gate layer 14 and from the titanium present in the first metal layer 56. In the embodiment considered by way of example, a first first-phase silicide sub-region 58a, a second first-phase silicide sub-region 58b, and a third first-phase silicide sub-region 58c are formed in areas corresponding to respective first-phase exposed regions 53' and respective first-phase openings 54; for example, the first, second, and third first-phase silicide sub-regions 58a, 58b, 58c are arranged in succession along the axis X (for example, proceeding from right to left in Figure 7D), and the first first-phase silicide sub-region 58a forms the first electrical-modulation region 25a.

In detail, formation of the first-phase silicide sub-regions 58 is carried out via one or more first thermal processes that enable mutual diffusion of silicon and titanium through the interface generated between the gate layer 14 and the first metal layer 56. For instance, the one or more first thermal processes are carried out in protected environment (e.g., in a nitrogen or argon atmosphere), at a temperature comprised between 300°C and 1100°C for a time interval comprised between 10 s and 300 s. In fact, the one or more first thermal processes enable diffusion of the silicon in the titanium and of the titanium in the silicon and lead to formation of the silicide via a progressive consumption of the portions of the gate layer 14 and of the first metal layer 56 that are in contact with one another at the first-phase openings 54. Consequently, the first-phase silicide sub-regions 58 extend in part in the gate layer 14 (from the top surface 14a to the bottom surface 14b of the gate layer 14) and in part in the first metal layer 56 (from a bottom surface of the first metal layer 56, facing the gate layer 14, to a top surface of the first metal layer 56 opposite to the bottom surface, along the axis Z). In detail, as the time interval in which the one or more first thermal processes are carried out increases, diffusion of the silicon and of the titanium at the interface increases and thus the thickness of the first-phase silicide sub-regions 58, measured along the axis Z, increases. In the embodiment considered by way of example, the time interval of the one or more first thermal processes is defined in such a way that the thickness t_{silic} of the first-phase silicide sub-regions 58 is equal to the thickness t_{silic} of the first electrical-modulation region 25a.

Greater details as regards formation of silicide starting from an interface between silicon and metal/semimetal may be found in prior-art documents, such as "Ti Nitrides and Ti Silicides", Isabelle Jauberteau, https://encyclopedia.pub/entry/119 and "NiSi salicide technology for scaled CMOS", Iwaia, et al., Microelectronic Engineering 60 (2002) 157-169.

Once again with reference to Figure 7D, there follows a step of removal of the titanium that has not reacted with the silicon of the gate layer 14. In other words, the portions of the first metal layer 56 that have not reacted with the gate layer 14 to form the silicide are removed. In this way, the first metal layer 56 is removed, leaving on the gate layer 14 the first-phase silicide sub-regions 58. For instance, this is obtained by carrying out a second first-phase etch that selectively removes the metal/semimetal of the first metal layer 56, without removing the silicide of the first-phase silicide sub-regions 58 and the oxide of the first mask layer 52. In detail, the second first-phase etch is an etch of a wet type with a base of hydrogen peroxide or solutions for etching of metals.

Once again with reference to Figure 7D and in a way not shown, there follows an optional step of removal of the first mask layer 52 so as to expose the first-phase covered regions 53" of the top surface 14a of the gate layer 14. In particular, this is obtained by carrying out a third first-phase etch that selectively removes the first mask layer 52, without removing the first-phase silicide sub-regions 58 and the gate layer 14. For instance, the third first-phase etch is a wet etch (e.g., HF-based) or else a plasma etch (e.g., via chlorine or fluorine compounds, such as XeF₂ or SF₆).

The steps described with reference to Figures 7B-7D lead to formation of the first-phase silicide sub-regions 58 and, in particular, to formation of the first electrical-modulation region 25a.

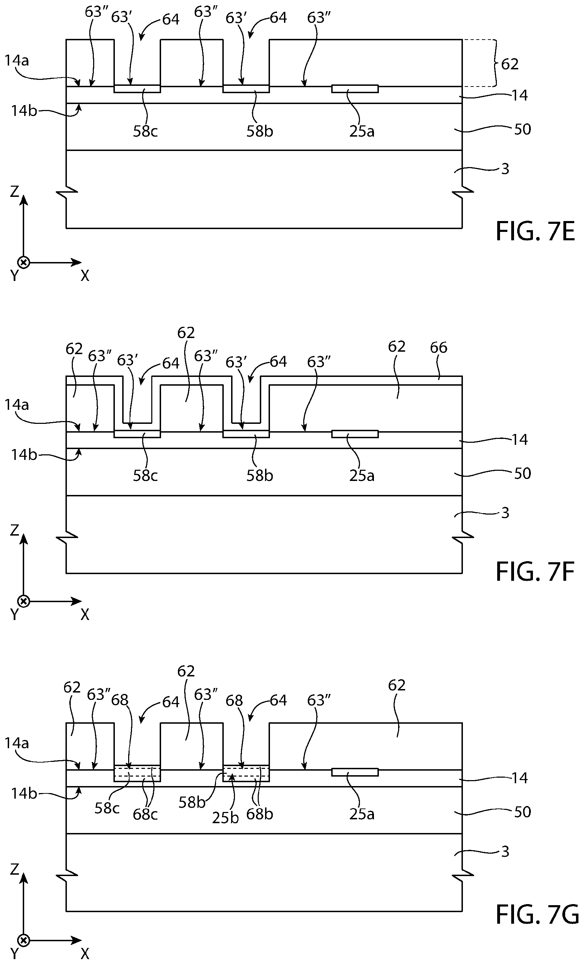

The steps described with reference to Figures 7B-7D may be repeated one or more times to form further silicide regions overlying part of the first-phase silicide sub-regions 58 (in detail, not overlying the first first-phase silicide sub-region 58a) so as to form electrical-modulation regions 25 with thicknesses t_{silic} different from one another. In particular, an example of this is described in what follows with reference to Figures 7E-7G.

With reference to Figure 7E, a second mask layer 62 is formed on the gate layer 14, i.e., on the top surface 14a of the gate layer 14. In particular, the second mask layer 62 exposes second-phase exposed regions 63' of the top surface 14a of the gate layer 14 and covers second-phase covered regions 63" of the top surface 14a of the gate layer 14; in particular, the second mask layer 62 covers the first first-phase silicide sub-region 58a (i.e., the first electrical-modulation region 25a). In detail, the second-phase exposed regions 63' are arranged alongside one another and at a distance from one another in the plane XY, for example along the axis X, and overlie, along the axis Z, the first-phase silicide sub-regions 58 of which the thickness t_{silic} is to be increased. In the embodiment considered by way of example, the second-phase exposed regions 63' overlie, respectively, the second first-phase silicide sub-region 58b and the third first-phase silicide sub-region 58c, while the first first-phase silicide sub-region 58a is covered by the second mask layer 62. In greater detail, the second mask layer 62 has a plurality of second-phase openings 64 that extend through the second mask layer 62 so as to expose the second-phase exposed regions 63' (overlying, along the axis Z, part of the first-phase exposed regions 53').

Furthermore, the second mask layer 62 is made of a material and is obtained in a way similar to what has been described previously with reference to the first mask layer 52. In particular, the second mask layer 62 is formed via deposition of a second intermediate oxide layer (similar to the first intermediate oxide layer), followed by a first second-phase etch (similar to the first first-phase etch) that forms the second-phase openings 64.

With reference to Figure 7F, a second metal layer 66 is formed on the second mask layer 62 and on the second first-phase silicide sub-region 58b and on the third first-phase silicide sub-region 58c (thus, in the second-phase openings 64 in such a way as to cover the second-phase exposed regions 63'). The second metal layer 66 is made of a material and is obtained in a way similar to what has been described with reference to the first metal layer 56 and will not be described any further.

With reference to Figure 7G, second-phase silicide sub-regions 68 are formed in areas corresponding to the second-phase exposed regions 63'. In particular, the second-phase silicide sub-regions 68 are also themselves comprised in the respective electrical-modulation regions 25 and are made of the silicide that is generated starting from the silicon present in the gate layer 14 and the titanium present in the second metal layer 66. In the embodiment considered by way of example, a first second-phase silicide sub-region 68b and a second second-phase silicide sub-region 68c are formed, which extend both above and beneath, along the axis Z, the second first-phase silicide sub-region 58b and the third first-phase silicide sub-region 58c, respectively. The first second-phase silicide sub-region 68b forms, together with the second first-phase silicide sub-region 58b, the second electrical-modulation region 25b.

The second-phase silicide sub-regions 68 are made of a material and obtained in a way similar to what has been described previously with reference to the first-phase silicide sub-regions 58 (e.g., formation is carried out via one or more second thermal processes similar to the one or more first thermal processes, followed by a second second-phase etch similar to the second first-phase etch and carried out for selective removal of the second metal layer 66). In particular, the time interval of the one or more second thermal processes is defined in such a way that the sum of the thickness t_{silic} of the second-phase silicide sub-regions 68 and of the thickness t_{silic} of the first-phase silicide sub-regions 58 is equal to the thickness t_{silic} of the second electrical-modulation region 25b.

Once again with reference to Figure 7D and in a way not shown, there follows an optional step of removal of the second mask layer 62 so as to expose the second-phase covered regions 63" of the top surface 14a of the gate layer 14. In particular, this is obtained by carrying out a third second-phase etch similar to the third first-phase etch.

Via the steps described with reference to Figures 7E-7G it is thus possible to increase the thickness t_{silic} of the silicide regions to form the second electrical-modulation region 25b.

Optionally and in a way not shown or discussed again in detail, the steps of Figures 7E-7G may be repeated as described previously to form the third electrical-modulation region 25c (in particular, covering the first and second electrical-modulation regions 25a, 25b via a third mask layer and forming a first third-phase silicide sub-region overlying, along the axis Z, the second second-phase silicide sub-region 68c). This enables formation of the gate region 24 as shown in Figure 4.

There then follows, in a way not shown, formation of a second oxide layer overlying, along the axis Z, of the gate layer 14 and the electrical-modulation regions 25. The second oxide layer forms the top portion 12a of the oxide layer 12 and is formed so as to join up to the first oxide layer 50; in other words, the first oxide layer 50 and the second oxide layer surround and bury the gate region 24, thus forming the oxide layer 12, for electrically insulating the gate region 24. The second oxide layer is made of a material and Is obtained in a way similar to what has been described previously with reference to the first oxide layer 50.

There then follow steps that are in themselves known and are not discussed any further, which lead to the formation of the power device 1 of Figure 1, amongst which formation of the source metallization 16 and of the drain metallization 6.

From an examination of the characteristics of the invention provided according to the present disclosure the advantages that it affords are evident.

In particular, the electrical-modulation regions 25 enable local and selective modulation of the electrical resistance of the gate region 24. In other words, the electrical resistance of the gate region 24 is locally variable. This is obtained thanks to the presence of the electrical-modulation silicide regions 25 and, more in particular, by controlling in the design stage the number of the electrical-modulation regions 25 and the structural parameters (the shape, thickness t_{silic}, area of extension A_{silic}, and minimum distance D_{silic}) of each of them. In this way, it is possible to supply the gate voltage V_{G} to the power device 1 in a synchronous and homogeneous way through all the elementary cells 1' (irrespective of the extension of the power device in a plane parallel to the plane XY and notwithstanding possible differences of propagation of the gate voltage V_{G} that there would be through the different areas of the power device 1 in the case of absence of the electrical-modulation regions 25), or else in a deliberately asynchronous and unhomogeneous way through the elementary cells 1'. This enables improved control of switching of the power device 1 and better electrical performance, as well as a greater reliability of the power device 1 (more robust to thermal breakdown as compared to known devices). Furthermore, it enables a specific design according to the application of the power device 1 and the corresponding design requirements.

In addition, the manufacturing process described with reference to Figures 7A-7G enables simple and low-cost production of the power device 1 and in particular makes it possible to obtain the electrical-modulation regions 25 with different thicknesses t_{silic}, in a self-aligned way and via techniques compatible with the typical manufacturing processes of power MOSFET devices.

Finally, it is clear that modifications and variations may be made to the invention described and illustrated herein, without thereby departing from the scope of the present disclosure, as defined in the annexed claims.

For instance, the different embodiments described may be combined with one another so as to provide further solutions.

Further, other embodiments of the gate structure 15 are possible. An example of this is provided in Figure 6, but further embodiments are possible as will be evident to the person skilled in the art. For instance, the shapes of the gate structures 15 of Figures 3A and 3B may be combined with one another to have a number of elementary cells 1' aligned with one another along each secondary portion 15". Or else the secondary portions 15" may be staggered one another in a direction parallel to the axis X, or else they may all be on one and the same side of the main portion 15'.

Furthermore, according to the specific layouts of the gate structure 15 and to the design requirements dictated by the specific application (e.g., which areas of the power device 1 must switch before or after), it is possible to design the electrical-modulation regions 25 that enable the gate region 24 to have the required electrical properties. This is obtained by controlling, in the design stage, the number of the electrical-modulation regions 25 and the structural parameters (the shape, the thickness t_{silic}, the area of extension A_{silic}, and the minimum distance D_{silic}) of each of them, even in a way different from what has been described previously purely by way of example. For instance, it is possible to have a number greater than three of electrical-modulation regions 25, it is possible to have a number electrical-modulation regions 25 with one and the same thickness t_{silic}, it is possible to have the electrical-modulation regions 25 with different minimum distances D_{silic} (in this case, the first-phase openings 54 and the second-phase openings 64 are not equally spaced apart along the axis X), it is possible to have the electrical-modulation regions 25 with shapes different from the square shape described previously and with shapes different from one another, etc. In detail, for a number N of electrical-modulation regions 25 having M thicknesses t_{silic} different from one another (with M ≤ N and M ≥ 2), the steps described with reference to Figures 7B-7D are likewise repeated M times, as described previously. Alternatively, in the case of electrical-modulation regions 25 with one and the same thickness t_{silic}, the steps described with reference to Figures 7A-7D and the final steps described after Figure 7G are carried out, without any need to perform the steps 7E-7G or likewise to repeat them.

The power device 1 may be of a type different from what has been described previously with reference to Figure 1. For instance, the gate structure 15 may be of a trench-gate type and thus extend in a recess present in the semiconductor body 3 starting from the front surface 3a. Or else the power device 1 may be of a DMOS type, an LDMOS type, a VMOS type, etc.

In fact, in its most general form and as is evidently known to the person skilled in the art, the power device 1 of a MOSFET type comprises, for each elementary cell 1' present in the active area 7: the drain region 5 with the first electrical conductivity type; the first source region 13a with the first electrical conductivity type; the first body region 9a with the second electrical conductivity type, where the first body region 9a is adjacent to the drain region 5 and to the first source region 13a and defines the first channel region 17a arranged between the first source region 13a and the drain region 5; and the gate structure 15, which overlies, along the axis Z, the drain region 5 and the first channel region 17a and may be electrically biased to control the first flow of charge carriers 18a through the first channel region 17a, between the first source region 13a and the drain region 5, where the first source region 13a, the drain region 5, and the first body region 9a are comprised in the semiconductor body 3.

Furthermore, in the case where the first mask layer 52 is made of photoresist, the manufacturing process presents the following differences as compared to what has been described previously. First of all, with reference to Figure 7B, the first mask layer 52 of photoresist is formed via photolithographic techniques in themselves known. Further, with reference to Figure 7D, the one or more first thermal processes are carried out after removing, via lift-off techniques in themselves known, the first mask layer 52 of photoresist and the parts of the first metal layer 56 overlying, along the axis Z, the first mask layer 52. Even though these differences have been listed with reference to the steps of Figures 7B-7D, they likewise apply to the subsequent repetitions of these steps (e.g., the steps of Figures 7E-7G).

## Claims

1. A power MOSFET device (1) comprising a semiconductor body (3) having a first main surface (3a) and a second main surface (3b) opposite to one another along a first axis (Z), the semiconductor body (3) including an active area (7) facing the first main surface (3a),
wherein the power MOSFET device (1) further comprises an isolated-gate structure (15), which extends over the active area (7) and includes a gate-oxide layer (12), which is made of insulating material and extends over the first main surface (3a), and a gate region (24) buried in the gate-oxide layer (12) so as to be electrically insulated from the semiconductor body (3),
wherein the gate region (24) comprises a gate layer (14) of polysilicon and at least one first silicide region (25a) and one second silicide region (25b), the gate layer (14) having a top surface (14a) and a bottom surface (14b) opposite to one another along the first axis (Z), the bottom surface (14b) of the gate layer (14) facing the main surface (3a) of the semiconductor body (3) through the gate-oxide layer (12), the first silicide region (25a) and the second silicide region (25b) extending in the gate layer (14) so as to face the top surface (14a) of the gate layer (14) and to be arranged alongside one another and spaced apart in a first plane (XY) orthogonal to the first axis (Z).

2. The power MOSFET device according to claim 1, comprising at least one first elementary cell (1') of the power MOSFET device (1'), the first elementary cell (1') extending in the active area (7) and comprising:
- a drain region (5) having a first electrical conductivity type;
- a first source region (13a) having the first electrical conductivity type;
- a first body region (9a) having a second electrical conductivity type opposite to the first type, the first body region (9a) being adjacent to the drain region (5) and to the first source region (13a) and defining a first channel region (17a) interposed between the first source region (13a) and the drain region (5); and
- the isolated-gate structure (15), which overlies, along the first axis (Z), the drain region (5) and the first channel region (17a) and is electrically biasable to control a first flow of charge carriers (18a) through the first channel region (17a), between the first source region (13a) and the drain region (5),
wherein the first source region (13a), the drain region (5), and the first body region (9a) are comprised in the semiconductor body (3).

3. The power MOSFET device according to claim 2, further comprising:
- a second source region (13b) having the first electrical conductivity type; and
- a second body region (9b) that has the second electrical conductivity type, is adjacent to the drain region (5) and to the second source region (13b) and defines a second channel region (17b) interposed between the second source region (13b) and the drain region (5),
wherein the isolated-gate structure (15) overlies, along the first axis (Z), also the second channel region (17b) and is electrically biasable also to control a second flow of charge carriers (18b) through the second channel region (17b), between the second source region (13b) and the drain region (5),
wherein the drain region (5) extends in the semiconductor body (3) starting from the second main surface (3b),
wherein the first body region (9a) and the second body region (9b) extend in the semiconductor body (3) starting from the second main surface (3b) and are separate from one another, orthogonally to the first axis (Z), via part of the drain region (5),
wherein the first source region (13a) and the second source region (13b) extend in the semiconductor body (3) starting from the second main surface (3b) and, orthogonally to the first axis (Z), are separated from the drain region (5) via the first body region (9a) and, respectively, the second body region (9b),
wherein the isolated-gate structure (15) has a first portion facing the first body region (9a) and the first source region (13a), and a second portion facing the second body region (9b) and the second source region (13b),
wherein the first body region (9a), the first source region (13a), the drain region (5), the first portion of the isolated-gate structure (15) and the first channel region (17a) form a first device portion (1a) of the first elementary cell (1'), and the second body region (9b), the second source region (13b), the drain region (5), the second portion of the isolated-gate structure (15) and the second channel region (17b) form a second device portion (1b) of the first elementary cell (1').

4. The power MOSFET device according to claim 2 or claim 3, further comprising at least one second elementary cell (1') of the power MOSFET device (1) electrically connected to the first elementary cell (1'), the second elementary cell (1') extending in the active area (7) and comprising:
- the drain region (5);
- a respective first source region (13a) having the first electrical conductivity type;
- a respective first body region (9a) having the second electrical conductivity type, the first body region (9a) of the second elementary cell (1') being adjacent to the drain region (5) and to the first source region (13a) of the second elementary cell (1') and defining a respective first channel region (17a) interposed between the first source region (13a) of the second elementary cell (1') and the drain region (5); and
- the isolated-gate structure (15), which overlies, along the first axis (Z), also the first channel region (17a) of the second elementary cell (1') and is electrically biasable to control a respective first flow of charge carriers (18a) through the first channel region (17a) of the second elementary cell (1'), between the first source region (13a) of the second elementary cell (1') and the drain region (5),
wherein the first source region (13a) of the second elementary cell (1') and the first body region (9a) of the second elementary cell (1') are comprised in the semiconductor body (3).

5. The power MOSFET device according to any one of the preceding claims, wherein each between the first silicide region (25a) and the second silicide region (25b) has respective structural parameters, the structural parameters comprising:
i. a shape of the first silicide region (25a) and of the second silicide region (25b), in a plane parallel to the first plane (XY);
ii. a maximum thickness (t_{silic}) of the first silicide region (25a) and of the second silicide region (25b), measured along the first axis (Z); and
iii. an area of maximum extension (A_{silic}) of the first silicide region (25a) and of the second silicide region (25b), measured in a plane parallel to the first plane (XY),
wherein at least one of the structural parameters i-iii is different between the first silicide region (25a) and the second silicide region (25b).

6. The power MOSFET device according to claim 5, wherein the first silicide region (25a) has a first maximum thickness (t_{silic}) and the second silicide region (25b) has a second maximum thickness (t_{silic}) greater than the first maximum thickness.

7. The power MOSFET device according to any one of the preceding claims, wherein the gate region (24) further comprises at least one third silicide region (25c), which extends in the gate layer (14) so as to face the top surface (14a) of the gate layer (14) and be at a distance from the first silicide region (25a) and from the second silicide region (25b) in the first plane (XY).

8. The power MOSFET device according to claim 7 and either claim 5 or claim 6, wherein the structural parameter i further comprises a shape of the third silicide region (25c) in a plane parallel to the first plane (XY),
wherein the structural parameter ii further comprises a maximum thickness (t_{silic}) of the third silicide region (25c), measured along the first axis (Z),
wherein the structural parameter iii further comprises an area of maximum extension (A_{silic}) of the third silicide region (25c), measured in a direction parallel to the first plane (XY),
wherein the structural parameters further comprise:
iv. a minimum distance (D_{silic}) measured, parallel to the first plane (XY), between the respective silicide regions (25a, 25b, 25c) of each pair of silicide regions (25a, 25b, 25c) adjacent to one another,
wherein at least one of the structural parameters i-iv is different between the first (25a), second (25b), and third (25c) silicide regions.

9. The power MOSFET device according to claim 7 or claim 8, wherein the first (25a), second (25b) and third (25c) silicide regions are aligned with one another in a direction of main extension (19) of the isolated-gate structure (15) to form an array of silicide regions.

10. The power MOSFET device according to any one of the preceding claims, wherein the gate region (24) comprises at least one first portion of the gate region (24) and at least one second portion of the gate region (24) that are adjacent to one another orthogonally to the first axis (Z), the at least one first portion of the gate region (24) comprising the first silicide region (25a) and the second silicide region (25b) and presenting a lower electrical resistance than the at least one second portion of the gate region (24).

11. The power MOSFET device according to any one of the preceding claims, wherein the semiconductor body (3) comprises silicon carbide, SiC.

12. A process for manufacturing a power MOSFET device (1), comprising the steps of:
- forming a semiconductor body (3) having a first main surface (3a) and a second main surface (3b) opposite to one another along a first axis (Z), the semiconductor body (3) including an active area (7) facing the first main surface (3a),
- forming, on the active area (7), an isolated-gate structure (15) of the power MOSFET device (1), the isolated-gate structure (15) including a gate-oxide layer (12), which is made of insulating material and extends on the first main surface (3a), and a gate region (24) buried in the gate-oxide layer (12) so as to be electrically insulated from the semiconductor body (3),
wherein the step of forming the isolated-gate structure (15) comprises, in succession:
- forming, on the first main surface (3a) of the semiconductor body (3), a first oxide layer (50) of insulating material;
- forming, on the first oxide layer (50), a gate layer (14) of polysilicon, the gate layer (14) having a top surface (14a) and a bottom surface (14b) opposite to one another along the first axis (Z), the bottom surface (14b) of the gate layer (14) facing the first oxide layer (50);
- forming, in the gate layer (14) and starting from the top surface (14a) of the gate layer (14), at least one first silicide region (25a) and one second silicide region (25b), the first silicide region (25a) and the second silicide region (25b) being arranged alongside one another and spaced apart in a first plane (XY) orthogonal to the first axis (Z) and forming, together with the gate layer (14), the gate region (24); and
- forming, on the gate layer (14) and on the first silicide region (25a) and on the second silicide region (25b), a second oxide layer (50) of insulating material, which, together with the first oxide layer (50), forms the gate-oxide layer (12) that surrounds the gate region (24).

13. The manufacturing process according to claim 12, wherein the step of forming the first silicide region (25a) and the second silicide region (25b) comprises, in succession the:
- forming, on the top surface (14a) of the gate layer (14), a first mask layer (52) that covers first-phase covered regions (53") of the top surface (14a) of the gate layer (14) and has a first first-phase opening (54) and a second first-phase opening (54) that are arranged alongside one another and spaced apart parallel to the first plane (XY) and that expose respective first-phase exposed regions (53') of the top surface (14a) of the gate layer (14);
- forming, on the first mask layer (52) and on the first-phase exposed regions (53') that are exposed by the first and second first-phase openings (54), a first metal layer (56) of metal or semimetal; and
- carrying out one or more first thermal processes to form, at the interface between the gate layer (14) and the first metal layer (56), a first first-phase silicide sub-region (58a) and a second first-phase silicide sub-region (58b) at the respective first-phase exposed regions (53'), the first first-phase silicide sub-region (58a) and the second first-phase silicide sub-region (58b) being comprised in the first silicide region (25a) and in the second silicide region (25b), respectively.

14. The manufacturing process according to claim 13, wherein the step of forming the first silicide region (25a) and the second silicide region (25b) further comprises, in succession:
- after carrying out the one or more first thermal processes, removing the first metal layer (56) and leaving the first first-phase silicide sub-region (58a) and the second first-phase silicide sub-region (58b) on the gate layer (14); and
- removing the first mask layer (52) from the gate layer (14) .

15. The manufacturing process according to claim 13 or claim 14, wherein the first first-phase silicide sub-region (58a) forms the first silicide region (25a),
wherein the step of forming the first silicide region (25a) and the second silicide region (25b) further comprises, in succession:
- after forming the first first-phase silicide sub-region (58a) and the second first-phase silicide sub-region (58b) on the gate layer (14), forming, on the top surface (14a) of the gate layer (14) and on the first first-phase silicide sub-region (58a), a second mask layer (62) that covers the first first-phase silicide sub-region (58a) and second-phase covered regions (63") of the top surface (14a) of the gate layer (14) and has a first second-phase opening (64) that exposes the second first-phase silicide sub-region (58b);
- forming, on the second mask layer (62) and on the second first-phase silicide sub-region (58b) exposed by the first second-phase opening (64), a second metal layer (66) consisting of metal or semimetal; and
- carrying out one or more second thermal processes to form, at the interface between the second first-phase silicide sub-region (58b) and the second metal layer (66), a first second-phase silicide sub-region (68) overlying, along the first axis (Z), the second first-phase silicide sub-region (58b), the second first-phase silicide sub-region (58b) and the first second-phase silicide sub-region (68) forming the second silicide region (25b).

16. The manufacturing process according to any one of claims 12-15, wherein the step of forming the semiconductor body (3) comprises forming, in the active area (7), at least one first elementary cell (1') of the power MOSFET device (1'), carrying out the steps of:
- forming, starting from a substrate of semiconductor material, a drain region (5) having a first electrical conductivity type and having a respective first main surface (3a) and a respective second main surface (3b) opposite to one another along the first axis (Z);
- forming, in the drain region (5) and starting from the first main surface (3a) of the drain region (5), a first body region (9a) having a second electrical conductivity type opposite to the first type; and
- forming, in the first body region (9a) and starting from the first main surface (3a) of the drain region (5), a first source region (13a) having the first electrical conductivity type,
wherein the first body region (9a) is adjacent to the drain region (5) and to the first source region (13a) and defines a first channel region (17a) arranged between the first source region (13a) and the drain region (5),
wherein the isolated-gate structure (15) overlies, along the first axis (Z), the drain region (5) and the first channel region (17a) and is electrically biasable to control a first flow of charge carriers (18a) through the first channel region (17a), between the first source region (13a) and the drain region (5), and
wherein the first source region (13a), the drain region (5), and the first body region (9a) are comprised in the semiconductor body (3), the first main surface (3a) of the drain region (5) defines the first main surface (3a) of the semiconductor body (3), and the second main surface (3b) of the drain region (5) defines the second main surface (3b) of the semiconductor body (3).
